# EUROPÄISCHE PATENTANMELDUNG

(11) **EP 1 139 104 A2**
(43) Veröffentlichungstag der Anmeldung: **04.10.2001**
(21) Anmeldenummer: 01102754.7
(22) Anmeldetag: 08.02.2001
(51) Int. Cl.: G01R 15/20

(54) **Mehrschichtige Anordnung elektrischer Leiter mit integrierter Stromerfassung**

(30) Priorität: 22.02.2000 DE 10007967
(71) Anmelder: DaimlerChrysler AG, 70567 Stuttgart (DE)
(72) Erfinder: Mäckel, Rainer, Dr., 53639 Königswinter (DE); Fischer, Roland, Dr., 61130 Nidderau (DE)
(74) Vertreter: Maute, Hans-Jürgen, Dipl.-Ing.

(57) **Zusammenfassung**

Eine Anordnung aus mehreren aufeinanderfolgenden Schichten enthält mindestens zwei Leiterbahnen, die voneinander durch mindestens eine Isolation getrennt sind. Jede dieser Leiterbahnen hat mindestens eine Meßstelle, an der die Leiterbahn mit Ausnehmungen versehen ist und diese Ausnehmungen die Strompfade in der Leiterbahn ausrichten. Jeder dieser Meßstellen ist mindestens ein Differenzsensor zugeordnet, der den Strom in der zugehörigen Leiterbahn erfaßt. Der magnetische Differenzsensor ist in die Anordnung integriert. Der magnetische Differenzsensor besteht mindestens aus zwei Hallplatten, die in Differenzschaltung zusammengeschaltet sind.

Durch die Integration der Strommessung auf der Platine kann auf ansonsten zusätzliche Stromerfassungssysteme für die in der Platine integrierten Leiterbahnen verzichtet werden.

## Beschreibung

Die Erfindung betrifft eine mehrschichtige Anordnung mit mehreren elektrischen Leitern mit integrierter Stromerfassung entsprechend den Merkmalen des unabhängigen Anspruchs.

Bei der Ansteuerung einer Anordnung von mehreren Elektromotoren, die zum Beispiel aus einem Elektromotor oder Brennstoffmotor als Antriebsmotor und mehreren Elektromotoren für Nebenaggregate bestehen kann, werden die für die einzelnen Elektromotoren notwendigen Ströme oft in Mehrfach-Platinen oder Mehrfach-Leiterplatten geführt, d.h. in mehreren Kupferschichten, die durch Isolatorschichten voneinander getrennt sind, aber durch elektronische Komponenten auf der Platine oder der Leiterplatte angesteuert und geregelt werden. Hierbei ist es für die Regelung und Absicherung der Ströme oft notwendig, diese von der gleichen Platine oder Leiterplatte aus zu messen.

Erfindungsgemäße Aufgabe ist es daher eine Anordnung anzugeben, mit der übereinander fließende Ströme oder nebeneinander fließende Ströme in einer mehrschichtigen Anordnung mit mehreren elektrischen Leitern durch eine Anordnung von Hallsensoren gemessen werden können.

Die Lösung dieser Aufgabe gelingt mit einer mehrschichtigen Anordnung elektrischer Leiter wie z.B einer Mehrfachplatine oder einer Mehrfach-Leiterplatte mit den Merkmalen des unabhängigen Anspruchs. Weitere vorteilhafte Ausgestaltungen sind in den Unteransprüchen angegeben.

Eine mehrschichtigen Anordnung elektrischer Leiter wie z.B einer Mehrfachplatine oder einer Mehrfach-Leiterplatte aus mehreren aufeinanderfolgenden Schichten enthält mindestens zwei Leiterbahnen, die voneinander durch mindestens eine Isolation getrennt sind. Jede dieser Leiterbahnen hat mindestens eine Meßstelle, an der die Leiterbahn mit Ausnehmungen versehen ist und diese Ausnehmungen die Strompfade in der Leiterbahn ausrichten. Jeder dieser Meßstellen ist mindestens ein Differenzsensor zugeordnet, der den Strom in der zugehörigen Leiterbahn erfaßt. Der magnetische Differenzsensor ist in die Anordnung integriert. Der magnetische Differenzsensor besteht mindestens aus zwei Hallplatten, die in Differenzschaltung zusammengeschaltet sind.

Durch die Integration der Strommessung auf der Platine kann auf ansonsten zusätzliche Stromerfassungssysteme für die in der Platine integrierten Leiterbahnen verzichtet werden.

Die Erfindung wird im folgenden anhand von Zeichnungen dargestellt und näher erläutert. Es zeigen:
- Fig.1: eine schematische dreidimensionale Explosionsdarstellung eines Differenzsensors und seiner relativen Positionierung gegenüber der mit Ausnehmungen versehenen Leiterbahn zur Erläuterung des in der Erfindung verwendeten Meßprinzips
- Fig. 2: eine besonders bevorzugte erfindungsgemäße mehrschichtige Leiterplatine in Seitenansicht als Schnittdarstellung und in Aufsicht schematisch teilweise als Explosionsdarstellung
- Fig. 3: eine andere bevorzugte erfindungsgemäße mehrschichtige Leiterplatine in Seitenansicht als Schnittdarstellung und in Aufsicht schematisch teilweise als Explosionsdarstellung

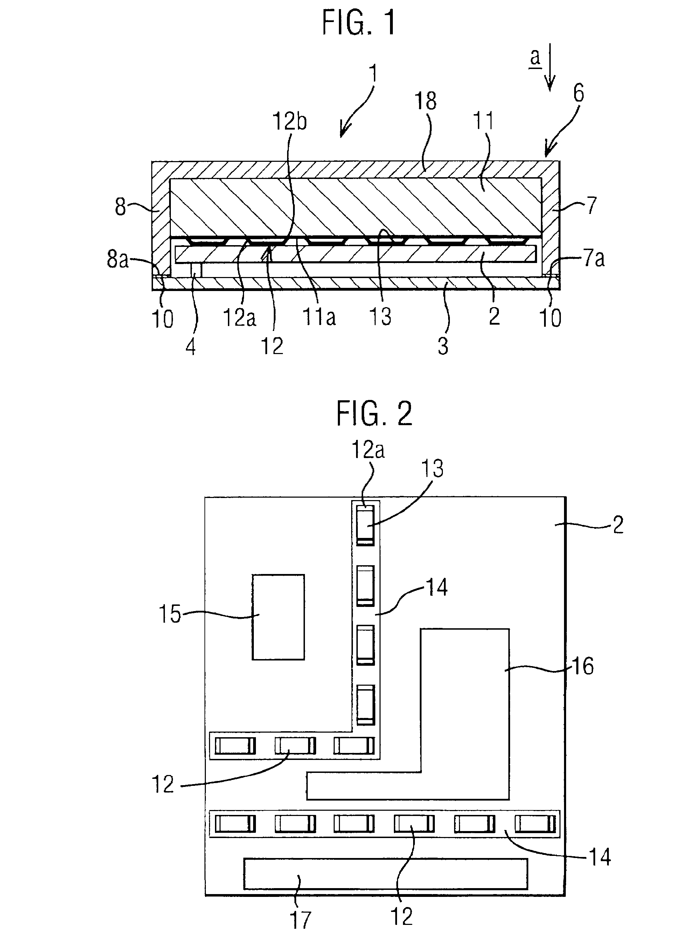

Fig.1 zeigt eine schematische dreidimensionale Explosionsdarstellung eines Differenzsensors und seiner relativen Positionierung gegenüber der mit Ausnehmungen versehenen Leiterbahn zur Erläuterung des in der Erfindung verwendeten Meßprinzips.
Ein Differenzsensor 1 wird an einer elektrischen Leiterbahn 2, die vorzugsweise aus einem metallischen Leiter gefertigt ist, angeordnet. Der Differenzsensor ist in an sich bekannter Weise aus zwei Hallplatten 3 gebildet, die auf einem Chip 4 angeordnet und verschaltet sind. Der Differenzsensor wird vorzugsweise monolithisch hergestellt und ist kommerziell in verschiedenen Konfigurationen erhältlich. Meist ist auf dem Chip auch noch eine Auswerteeinheit mit integriert, so daß das Meßsignal ΔU_{H} direkt vom Sensor z.B. in digitaler Form ausgelesen werden kann. Die beiden Hallplatten sind beispielsweise in einem Abstand von 1-10 mm voneinander angebracht. Der Abstand der Hallplatten richtet sich nach der Dimensionierung der Strombrücke 5, deren Dimensionierung sich wiederum nach dem vorgesehenen Strom richtet, den die Leiterbahn 2 führen soll. Die Leiterbahn 2 weist schlitzförmige, längliche, rechteckförmige Ausnehmungen 6 auf, in die der Differenzsensor mit seinen Hallplatten 3 eingepasst werden kann. Die Dimensionen der Ausnehmungen sind beispielhafterweise in der gleichen Größenordnung wie die Dimensionen der Strombrücke 5. Die Ausnehmungen 6 leiten den Gesamtstrom I in der Leiterbahn 2 auf einem S-förmigen Strompfad um die beiden Hallelemente 3 des Differenzsensors 1. Damit wird jedes der Hallelemente 3 an drei Seiten von dem Gesamtstrom I, der im Leiter 2 geführt wird, umflossen, so daß sich die Magnetfeldanteile der einzelnen Leiterabschnitte des S-förmigen Strompfads um die Hallplatten 3 am Ort der Hallplatten verstärkend überlagern. Der Differenzsensor 1 ist in Hauptstromrichtung, symbolisiert durch die Strompfeile 7, an der Leiterbahn 2 angeordnet. In anderen Worten ist der Differenzsensor 1 an der Leiterbahn 2 derart angeordnet, daß sich die beiden Hallplatten 3 auf einer gedachten gemeinsamen Linie, vorzugsweise der Mittellinie, in Längsrichtung parallel zur Hauptstromrichtung 7 befinden. Weiterhin ist in Fig. 1 der Vollständigkeit halber schematisch eine Stromversorgung der beiden Hallplatten mit einem Strom I_{const} gezeigt.

Da die Hallplatten Magnetfelder richtungsabhängig messen, d.h. bei entgegengesetzter Richtung des Magnetfeldes sich die Polarität der Hallspannung ändert, wird durch die in Fig. 1 beschriebene Anordnung eines Differenzsensors mit einer speziell ausgestalteten Leiterbahn eine Vorrichtung geschaffen, die die Differenz zweier etwa gleich großer Hallspannungen mit entgegengesetztem Vorzeichen mißt. Dadurch werden Spannungsanteile, die am Ort des Differenzsensors 1 keine Differenz aufweisen, wie z.B. das Erdmagnetfeld oder Offsetanteile der Hallplatten 3, nicht gemessen. Außerdem wird eine Verstärkung des nutzbaren Meßsignals um den Faktor 2 erreicht.

Streufelder von benachbarten stromführenden Leiterbahnen, die in einer parallelen Ebene einer Mehrfachplatine, wie in den Fig. 2 bis 5 gezeigt, angeordnet sind, haben auf die Stromerfassung durch einen magnetischen Differenzsensor nach Fig. 1 nur dann einen Einfluß wenn das Magnetfeld dieser benachbarten Leiterbahnen am Ort des Differenzsensors der ersten Leiterbahn Differenzanteile aufweist. Ist dies nicht der Fall, so haben die Streufelder von parallelen Leiterbahnen auf die Stromerfassung durch den Differenzsensor der ersten Leiterbahn keinen Einfluß. Dieses Prinzip wird erfindungsgemäß mit Vorteil für den Aufbau von mehrschichtigen Leiterplatinen mit integrierter Stromerfassung genutzt.

Solche mehrschichtigen Leiterplatinen sind beispielhaft in den Fig. 2 und Fig. 3 gezeigt. Eine Mehrfachplatine oder Mehrfach-Leiterplatte 8 aus mehreren abwechselnd aufeinanderfolgenden Schichten enthält auf einem Träger 9 mindestens zwei Leiterbahnen 2, 2a, die voneinander durch mindestens eine Isolatorschicht 10 getrennt sind. Jede dieser Leiterbahnen 2, 2a hat mindestens eine Meßstelle 11, 11a an der die Leiterbahn 2, 2a mit Ausnehmungen versehen ist und diese Ausnehmungen die Strompfade in der Leiterbahn 2, 2a ausrichten. In der Nähe dieser Meßstellen 11, 11a oder an den Meßstellen ist jeweils mindestens ein magnetischer Differenzsensor 1, 1a angebracht, der ebenfalls in die Mehrfachplatine oder Mehrfach-Leiterplatte integriert ist. Der magnetische Differenzsensor 1,1a besteht wie in Fig. 1 und zugehöriger Beschreibung erläutert mindestens aus zwei Hallplatten, die in Differenzschaltung zusammengeschaltet sind. Die Versorgungsleitungen und für die Hallplatten sowie die Meßleitungen zum Abgriff der Hallspannung sind in Fig. 2 nicht gezeigt. Wie und wo diese Leitungen verlegt sind, ist dem Fachmann überlassen. Der Fachmann wird den für die jeweilige Anwendung der Platine günstigsten Verlauf dieser Versorgungsleitungen und Meßleitungen wählen. Der günstigste Verlauf hängt von der Bestückung der Platine mit Bauelementen ab. Hierfür gibt es bekanntlich unzählige Möglichkeiten, die hier aufzuzählen nicht möglich ist. Wie und Wo diese Zuleitungen und Meßleitungen verlaufen stellt kein erfindungswesentliches Merkmal dar. Es seien deshalb beispielhaft lediglich zwei Möglichkeiten angegeben. Die Verlegung dieser Leitung kann z. B auf oder im Träger 9 erfolgen. In dem Ausführungsbeispiel nach Fig. 2 enthält die mehrschichtige Leiterplatine 8 zwei getrennte Leiterbahnen 2, 2a, die in verschiedenen Schichten zueinander parallelen Schichten der Leiterplatine verlaufen. Die Leiterbahnen können jedoch in einer anderen Ausführungsform auch getrennt voneinander in derselben Schicht der Platine verlaufen. Weiterhin enthält das Ausführungsbeispiel nach Fig. 2 zwei Meßstellen 11 und 11a, denen jeweils ein Differenzsensor 1, la zugeordnet ist. Der Differenzsensor 1 ist der Meßstelle 11 und der Differenzsensor la der Meßstelle 11a zugeordnet. Damit mißt der Differenzsensor 1 den Strom in der -Leiterbahn 2 und der Differenzsensor la den Strom in der Leiterbahn 2a. Die Anzahl der mit Meßstellen versehenen Leiterbahnen und den ihnen zugeordneten Differenzsensoren ist beliebig erweiterbar. Eine Erweiterung kann hierbei sowohl dadurch erfolgen, daß die zusätzlichen Leiterbahnen in horizontaler Richtung in einer Schicht nebeneinander liegen, als auch dadurch, daß in zusätzlichen Schichten einer erweiterten Mehrfachplatine oder Mehrfach-Leiterplatte weitere Leiterbahnen 2, 2a in vertikaler Richtung hinzugefügt werden. In dem letzteren Fall müßten die einzelnen Schichten der Leiterbahnen jeweils durch eine Isolierschicht 10 von der nächsten Leiterbahn getrennt werden. Im Falle der nebeneinander liegenden Leiterbahnen in ein und derselben Schicht der Leiterplatine ergibt sich eine Isolierung der Leiterbahnen voneinander bereits durch die dann vorhandene räumliche Distanz. Die Zwischenräume zwischen den Leiterbahnen innerhalb einer Schicht der Platine werden jedoch üblicherweise mit einem elektrisch isolierenden Material aufgefüllt, um die Stabilität der Mehrfachplatine oder Mehrfach-Leiterplatte zu erhöhen. Beispielhaft seien Mehrfachplatinen mit 2 bis 5 getrennten Leiterbahnen, oder Mehrfachplatinen mit 5 bis 10 getrennten Leiterbahnen oder Mehrfachplatinen mit 10 bis 100 getrennten Leiterbahnen oder Mehrfachplatinen mit 100 bis 1000 getrennten Leiterbahnen erwähnt. Die Anzahl der möglichen Leiterbahnen ist prinzipiell unbegrenzt und wird in der Anwendung nur von der jeweiligen vorgesehenen Anwendung der Platine und dem jeweils realisierten Platinen-Layout begrenzt.

Die Meßstellen 11 und 11a sind voneinander räumlich getrennt. Die Meßstellen werden durch die Ausnehmungen 6 in der Leiterbahn 2, 2a charakterisiert. Diese Ausnehmungen 6 bewirken eine gezielte Festlegung und Führung des Strompfades in den Leiterbahnen. Ein Beispiel eines möglichen Strompfades ist in Fig. 1 zur Erläuterung im Detail diskutiert. Wesentlich ist, daß der Strompfad am Ort des zugeordneten Differenzsensors ein Magnetfeld ausbildet, daß Differenzanteile aufweist und daß diese Differenzanteile proportional zu dem in der Leiterbahn fließenden Strom sind. Eine Möglichkeit diese Meßstellen auszubilden ist in Fig. 2 gezeigt, bei der die Strompfade wie in Fig. 1 ausgebildet sind. Eine erste Meßstelle 11 mit Ausnehmungen 6 ist in einer ersten Leiterbahn 2 angeordnet. Dieser ersten Meßstelle 11 ist ein erster Differenzsensor 1 zugeordnet, der den Strom in der ersten Leiterbahn 2 erfaßt. Eine weitere Meßstelle 11a ist von der ersten Meßstelle 11 räumlich getrennt und ist mit Ausnehmungen 6 in einer weiteren Leiterbahn 2a angeordnet. Dieser weiteren Meßstelle 11a ist ein weiterer Differenzsensor la zugeordnet, der den Strom in der weiteren Leiterbahn 2a erfaßt. Da die Magnetfelder der Leiterbahnen 2, 2a nur an den Meßstellen, bedingt durch die Ausnehmungen 6, Differenzanteile aufweisen, und da die Meßstellen 11, 11a voneinander räumlich getrennt sind, beeinflußt das Magnetfeld der ersten Leiterbahn 2 die Stromerfassung an der Meßstelle 11a nicht. Ebenso vice versa beeinflußt das Magnetfeld der Leiterbahn 2a die Stromerfassung an der Meßstelle 11 nicht. Dies ist immer dann der Fall, wenn die räumliche Trennung hinreichend groß ist. Die Trennung ist hinreichend groß, wenn sich die Differenzanteile des Magnetfeldes der ersten Meßstelle 11 nicht mit den Differenzanteilen des Magnetfeldes der weiteren Meßstelle 11a überlappen. Die Trennung der Meßstellen kann also räumlich in beliebiger Richtung vorgenommen werden und das Maß der räumlichen Trennung hängt nur von der Ausdehnung der Magnetfelder an den Meßstellen ab. Die konkrete Ausdehnung dieser Magnetfelder hängt von vielerlei Faktoren ab, wie z. B. Stromstärke, Abschirmungen, Dicke der Isolierschicht, konstruktive Gestaltung der Ausnehmungen 6, Platinen-Layout u.s.w. Es ist deshalb nicht möglich alle Möglichen Varianten anzugeben. Jedoch ist dem Fachmann mit dieser Beschreibung eine technische Lehre an die Hand gegeben, mit der er die für den jeweiligen Anwendungsfall der Platine angemessene räumliche Trennung auffindet.

In dem Ausführungsbeispiel nach Fig. 2 ist diese räumliche Trennung der Meßstellen sowohl in Bezug auf die Platinenebenen 9, 10, 2, 2a sowohl in horizontaler Richtung als auch in vertikaler Richtung gegeben. In dem Ausführungsbeispiel nach Fig. 2 sind die Differenzsensoren vorzugsweise in einer einzigen Sensorschicht 10 in die Mehrfachplatine oder Mehrfach-Leiterplatte 8 integriert. Der Schichtaufbau der Mehrfachplatine oder Mehrfach-Leiterplatte 8 erfolgt hierbei mit an sich bekannten Aufbautechniken und ist deshalb hier nicht gesondert erläutert. Die Anordnung der verschiedenen Differenzsensoren in einer einzigen Sensorschicht 10 hat den Vorteil , daß die Verdrahtung der Differenzsensoren ebenfalls in der Sensorschicht 10 erfolgt und damit von den übrigen Leiterbahnen 2, 2a die in der Mehrfachplatine oder Mehrfach-Leiterplatte ebenfalls in zusätzlichen schichten vorhanden sind auf elegante Weise entflechtet ist. Zudem bewirkt eine kompakte zusätzliche Sensorschicht 10 hinsichtlich Stabilität der ganzen Mehrfachplatine oder Mehrfach-Leiterplatte Vorteile. Eine zusätzliche sensorschicht10 erhöht die Steifigkeit der Mehrfachplatine oder Mehrfach-Leiterplatte und wird deshalb mit Vorteil bei Anwendungen eingesetzt, bei denen es auf die Steifigkeit der Platine ankommt.

Das Ausführungsbeispiel nach Fig. 3 unterscheidet sich von dem Ausführungsbeispiel nach Fig. 2 durch die unterschiedliche konstruktive Gestaltung der Ausnehmungen 6 an den Meßstelle 11, 11a sowie durch die unterschiedliche Anbringung der Differenzsensoren 1, la in der Mehrfachplatine oder Mehrfach-Leiterplatte 8. Die Differenzsensoren 11, 11a sind in diesem Ausführungsbeispiel in Bohrungen 13, die in die Mehrfachplatine oder Mehrfach-Leiterplatte 8 eingebracht sind, angeordnet. Hierdurch kann auf eine zusätzliche Sensorschicht wie in Fig. 2 verzichtet werden. Dies ist dann von Vorteil, wenn die Mehrfachplatine oder Mehrfach-Leiterplatte zwecks Materialeinsparungen mit möglichst wenig Schichten gefertigt werden muß. Weiterhin ist der konstruktive Aufwand bei der Ausgestaltung der Meßstellen 11, 11a durch die Ausnehmungen 6 gegenüber dem Ausführungsbeispiel nach Fig. 2 verringert. Die Anzahl der Ausnehmungen 6 ist nämlich von 4 auf 3 pro Meßstelle 11, 11a verringert. Dies bewirkt natürlich eine unterschiedliche Stromführung und damit im Vergleich mit Fig. 2 einen veränderten Strompfad in den Meßstellen 11, 11a. Die Bohrung 13 durchdringt in diesem Ausführungsbeispiel die Strombrücke 5 der einzelnen Leiterbahnen 2, 2a und bildet damit eine der drei Ausnehmungen 6 der Meßstellen 11, 11a. In den Bohrungen 13 ist pro Meßstelle 11,11a jeweils ein Differenzsensor 1, la angeordnet. Die Anordnung der Differenzsensoren 11, 11a in den Bohrungen 13 ist hierbei derart gewählt, daß sich jeweils eine Hallplatte oberhalb der Leiterbahn 2, 2a und eine Hallplatte unterhalb der Leiterbahn 2, 21 befindet. Das Ausführungsbeispiel hat damit den weiteren Vorteil, daß die Differenzsensoren nachträglich in die Mehrfachplatine oder Mehrfach-Leiterplatte 8 eingebracht werden können und die Anbringung der Differenzsensoren in der Mehrfachplatine oder Mehrfach-Leiterplatte reversibel gestaltet werden kann. Durch eine lösbare Anbringung der Differenzsensoren ist es möglich defekte Differenzsensoren auszutauschen.

## Patentansprüche

1. Eine Anordnung (8) aus mehreren aufeinander folgenden Schichten (2,2a,9,10) enthält mindestens zwei Leiterbahnen (2, 2a), die voneinander durch mindestens eine Isolation (10) getrennt sind,
jede dieser Leiterbahnen (2,2a) hat mindestens eine Meßstelle (11,11a), an der die Leiterbahn mit Ausnehmungen (6) versehen ist, und diese Ausnehmungen (6) die Strompfade in der Leiterbahn (2,2a) ausrichten,
jeder dieser Meßstellen (11,11a) ist mindestens einen magnetischen Differenzsensor (1,1a) zugeordnet, der den Strom in der zugehörigen Leiterbahn (2,2a) erfaßt,
der magnetische Differenzsensor (1,1a) ist in die Mehrfachplatine (8) integriert,
und der magnetische Differenzsensor (1,1a) besteht mindestens aus zwei Hallplatten (3), die in Differenzschaltung zusammengeschaltet sind.

2. Anordnung nach Anspruch 1, **dadurch gekennzeichnet, daß** die Leiterbahnen (2, 2a) getrennt voneinander in einer gemeinsamen Schicht angeordnet sind.

3. Anordnung nach Anspruch 1, **dadurch gekennzeichnet, daß** die Leiterbahnen (2, 2a) in verschiedenen zueinander parallelen Schichten (2, 2a) angeordnet sind.

4. Anordnung nach Anspruch 3, **dadurch gekennzeichnet, daß** die Leiterbahnen (2,2a) jeweils eine vollständige Schicht (2,2a) der Anordnung (8) bilden.

5. Anordnung nach Anspruch 3 oder 4 , **dadurch gekennzeichnet, daß** die Leiterbahnen (2,2a) durch eine Isolationsschicht (10) getrennt sind.

6. Anordnung nach einem der Ansprüche 1 bis 5, **dadurch gekennzeichnet, daß** die Differenzsensoren (1,1a) in einer gemeinsamen Sensorschicht (12) angeordnet sind.

7. Anordnung nach einem der Ansprüche 1 bis 5, **dadurch gekennzeichnet, daß** die Differenzsensoren (1,1a) in Bohrungen (13) der Anordnung (8) angeordnet sind.

8. Anordnung nach Anspruch 7, **dadurch gekennzeichnet, daß** die Differenzsensoren (1,1a) in die Anordnung reversibel integriert sind.
